Europäisches Patentamt

(19) European Patent Office

Office européen des brevets

(11) Publication number: **0 002 105**
**B1**

(12) # EUROPEAN PATENT SPECIFICATION

(21) Application number: **78300499.7**

(22) Date of filing: **13.10.78**

(51) Int. Cl.³: **G 03 F 7/08**

---

(54) Process for increasing the solubility rate ratio of a positive-working resist

---

(30) Priority: **23.11.77 US 854440**

(43) Date of publication of application:
**30.05.79 Bulletin 79/11**

(45) Publication of the grant of the European patent:
**14.01.81 Bulletin 81/02**

(84) Designated Contracting States:
**DE FR GB SE**

(56) References cited:
**GB - A - 1 066 366**
**US - A - 3 269 837**
**US - A - 3 402 044**
**US - A - 3 961 100**
**US - A - 3 961 101**

**CHEMICAL ABSTRACTS, vol. 84, 1976**
**Columbus, Ohio, USA**
**WATANABE: "Photosensitive imaging sheets containing o-Quinone diazide derivatives"**
**abstract no. 114221n**

**DERWENT JAPANESE PATENT REPORTS;**
**Derwent Publications Ltd.,**
**London, (GB)**
**vol. X27, issued 11-8-1976, the**
**JP - A - 76 56226 (SAM EI CHEM. IND.)**

(73) Proprietor: **International Business Machines Corporation, Armonk, N.Y. 10504 (US)**

(72) Inventor: **Carothers, James Albert**
**2706 Scottsdale Dr.**
**San José, California 95122 (US)**
**Economy, James**
**6694 Heathfield**
**San José, California 95120 (US)**
**Ouano, Augustus Ceniza**
**6133 Valley Glen Dr.**
**San José, California 95123 (US)**

(74) Representative: **Chaudhry, Mohammad Saeed**
**IBM United Kingdom Patent Operations**
**Hursley Park, Winchester, Hants, SO21 2JN (GB)**

Courier Press, Leamington Spa, England.

# 0 002 105

## Process for increasing the solubility rate ratio of a positive-working resist

The present invention relates to a process for increasing the solubility rate ratio of a positive working, photo-or electron beam-resist including a phenol-aldehyde resin and a quinone-diazo or quinone-triazo sensitizer.

Various methods of increasing solubility rate ratio or shortening development time have been used in the prior art. U.S Patent 3,961,100 describes a process in which the resist film is contacted with an aqueous alkaline developer solution prior to exposure. U.S Patent 3,961,101 describes a two-stage development process in which a water wash is employed between stages.

U.K. Patent 1,066,366 discloses a process of producing a positive printing plate from a negative original in which a light sensitive layer is exposed to light and the exposed material is developed by means of an aqueous alkaline developing solution such as triethylamine solution which removes the exposed portion of the light sensitive layer.

According to the present invention there is provided a process for increasing the solubility rate ratio of a positive-working, photo-or electron beam-resist including a phenol-aldehyde resin and a quinone-diazide sensitizer, characterised in that the resist is contacted, before the resist is developed, with a liquid trialkylamine containing from two to eight carbon atoms in each alkyl group so as to increase, when the resist imagewise exposed to radiation is developed, the ratio of the rate at which the exposed region of the resist is dissolved and the rate at which the unexposed region is dissolved.

The expression "solubility rate ratio" refers to the ratio between the rate at which the exposed region of the resist is dissolved and the rate at which the unexposed region is dissolved.

The resist may be contacted with the amine either before or after the resist has been imagewise exposed to radiation. It is, however, preferred that the contacting take place after imagewise exposure, because in cases where it takes place before the exposure, traces of residual amine may remain and be an undesired contaminant during the irradiation step.

The optimum time of contact between the amine and the resist will vary with the depth of etch profile desired. Preferably the contact time is from one minute to 30 minutes. It is advantageous to use very high purity amine. The process should preferably be carried out under anhydrous conditions.

The following example is given solely for purposes of illustration and is not to be considered limitative on the invention.

Photo or electron beam resist material of the type described above is coated on a substrate, i.e. 1 to 3 $\mu$m thick resist on silicon wafers by spin coating technique. The coated wafers are then baked at ca. 85°C. to 95°C. for thirty minutes. After baking, the wafers are exposed to light through a mask, which defines the patterns desired, or to an electron beam. The exposed wafers are subsequently immersed in a bath of the trialkylamine for the desired length of time (1 to 30 minutes) depending on the thickness of the resist, the trialkylamine used and the desired profile of the developed pattern. After soaking the exposed resist, it is spun dried for ca. one minute and immediately developed in an appropriate developer which is either aqueous potassium hydroxide solution of approximately 0.25 normal concentration or a highly buffered sodium hydroxide sodium silicate water solution for a desired length of time which depends on the image profile desired, the trialkylamine used and the intensity of radiation.

The results are shown below in Table I. For controls, experiments are shown with no treatment, with ammonia treatment, and with trimethylamine treatment. As can be seen from the table, treatment with ammonia is actually harmful, and treatment with trimethylamine produces very little result. On the other hand, treatment with the amines used in the process of the present invention yields very beneficial results.

TABLE I

| Treatment | So $\text{Å/Min}$ | S $\text{Å/Min}$ | S/So | $T_E$ (Secs.) | $T_U$ (Secs.) |
|---|---|---|---|---|---|
| None | 660 | 3,460 | 5.6 | 0 | 150 |
| $NH_3$ | 8,400 | 16,000 | 1.9 | 0 | 0 |
| $(CH_3)_3N$ | 600 | 5,100 | 8.5 | 0 | 150 |
| $(CH_3CH_2)_3N$ | 470 | 4,900 | 10.4 | 0 | 200 |
| $(CH_3CH_2CH_2)_3N$ | 210 | 3,300 | 15.7 | 60 | 350 |
| $(CH_3CH_2CH_2CH_2)_3N$ | 0 | 923 | $\infty$* | 300 | 800 |

# 0 002 105

Footnotes to Table I

S and $S_o$ are the solubility rates of the exposed and unexposed portions respectively.
$T_E$ and $T_U$ are the dissolution induction times of exposed and unexposed resist respectively.

1 Å $= 10^{-10}$ m.

*With tributylamine the image was fully developed without dissolution taking place in the unexposed regions of the resist. The $T_U$ was longer than the development time.

## Claims

1. A process for increasing the solubility rate ratio of a positive-working, photo- or electron beam-resist including a phenol-aldehyde resin and a quinone diazide sensitizer, characterised in that the resist is contacted, before the resist is developed, with a liquid trialkylamine containing from two to eight carbon atoms in each alkyl group so as to increase, when the resist imagewise exposed to radiation is developed, the ratio of the rate at which the exposed region of the resist is dissolved and the rate at which the unexposed region is dissolved.

2. A process as claimed in claim 1, wherein the amine is tributylamine.

3. A process as claimed in claim 1, wherein the amine is tripropylamine.

4. A process as claimed in any one of claims 1 to 3, wherein the resist is contacted with said liquid trialkylamine for 1 to 30 minutes.

5. A process as claimed in any one of the preceding claims, wherein the resist is contacted with said liquid trialkylamine after imagewise exposure of the resist to radiation.

6. A process as claimed in any one of the preceding claims, wherein the resist is contacted with the liquid trialkylamine under anhydrous conditions.

## Revendications

1. Procédé pour accroître le taux de solubilité d'un matériau sensible soit à la lumière, soit aux électrons, de type positif, comprenant une résine phénol-aldéhyde et un sensibilisateur quinone-diazide ou quinone-triazide, caractérisé en ce que le matériau sensible est mis en contact, avant le développement du matériau sensible, avec de la trialkylamine liquide contenant de deux à huit atomes de carbone dans chaque groupe alkyl de façon à accroître, lors du développement du matériau le rapport des vitesses de dissolution des zones exposées et des zones non-exposées.

2. Procédé selon la revendication 1 caractérisé en ce que l'amine est de la tributylamine.

3. Procédé selon la revendication 1 caractérisé en ce que l'amine est de la tripropylamine.

4. Procédé selon l'une quelconque des revendications 1 à 3, caractérisé en ce que le matériau sensible est mis en contact avec ladite trialkylamine liquide pendant 1 à 30 minutes.

5. Procédé selon l'une quelconque des revendications précédentes, caractérisé en ce que le matériau sensible est mis en contact avec ladite trialkylamine liquide après l'exposition du matériau sensible à la radiation selon la configuration désirée.

6. Procédé selon l'une quelconque des revendications précédentes, caractérisé en ce que le matériau photo-résistant est mis en contact avec la trialkylamine liquide dans des conditions anhydres.

## Patentansprüche

1. Verfahren zur Erhöhung des Verhältnisses der Lösungsgeschwindigkeit eines positiv arbeitenden Photo- oder Elektronenstrahlresists mit einem Gehalt an einem Phenolaldehydharz und einem Chinondiazid-Sensibilisator, dadurch gekennzeichnet, daß der Resist vor der Entwicklung mit einem Trialkylamin mit zwei bis acht Kohlenstoffatomen in jeder Alkylgruppe behandelt wird, damit während der Entwicklung des bildmäßig bestrahlten Resists das Verhältnis der Geschwindigkeit, mit der der bestrahlte Bereich gelöst wird zu der, mit der der nichtbestrahlte Bereich gelöst wird, erhöht wird.

2. Verfahren nach Anspruch 1, dadurch gekennzeichnet, daß das Amin Tributylamin ist.

3. Verfahren nach Anspruch 1, dadurch gekenzeichnet, daß das Amin Tripropylamin ist.

4. Verfahren nach einem der Ansprüche 1 bis 3, dadurch gekennzeichnet, daß der Resist 1 bis 30 Minuten lang mit dem flüssigen Trialkylamin behandelt wird.

5. Verfahren nach einem der vorhergehenden Ansprüche, dadurch gekennzeichnet, daß der Resist nach der bildmäßigen Bestrahlung mit dem flüssigen Trialkylamin behandelt wird.

6. Verfahren nach einem der vor hergehenden Ansprüche, dadurch gekennzeichnet, daß der Resist mit wasserfreiem flüssigem Trialkylamin behandelt wird.